Europäisches Patentamt

European Patent Office

Office européen des brevets

(19)

(11)  **EP 0 993 115 A2**

(12)  # EUROPEAN PATENT APPLICATION

(43) Date of publication:
   **12.04.2000   Bulletin 2000/15**

(51) Int Cl.⁷: **H03H 11/40**

(21) Application number: **99402449.5**

(22) Date of filing: **07.10.1999**

(84) Designated Contracting States:
   **AT BE CH CY DE DK ES FI FR GB GR IE IT LI LU
   MC NL PT SE**
   Designated Extension States:
   **AL LT LV MK RO SI**

(30) Priority:  **07.10.1998   JP  28554398**

(71) Applicant: **SONY CORPORATION
   Tokyo (JP)**

(72) Inventor: **Hirabayashi, Atsushi,
   Sony Corporation
   Tokyo (JP)**

(74) Representative: **Thévenet, Jean-Bruno et al
   Cabinet Beau de Loménie
   158, rue de l'Université
   75340 Paris Cédex 07 (FR)**

(54)  **Impedance circuit and phase shifter**

(57)   In an impedance circuit and phase shifter according to the while transistors (Q1, Q3) and (Q2, Q4) corresponding to each other are series-connected with each other to thereby form both a first differential pair and a second differential pair, since a current of this first differential paired transistor (Q1, Q2) is shunted and the shunted current drives the second differential paired transistor (Q3, Q4) in a reverse polarity, a desired impedance is formed as viewed from an input side of the first differential paired transistor (Q1, Q2) in a manner in which an impedance (13, 14) appearing in the emitters of the first differential paired transistor (Q1, Q2) is canceled by another impedance appearing (15, 16) in the emitters of the second differential paired transistor (Q3, Q4). Also, this impedance is set to be a capacitive impedance. The phase shifter is operable even under low power supply voltage and also firmly operable in a wide frequency range.

*FIG. 2*

**Description**

**BACKGROUND OF THE INVENTION**

Field of the Invention

The present invention is related to an impedance circuit and a phase shifter. These impedance circuit and phase shifter may be applied to such an integrated circuit which is applicable to, for instance, a radio receiver, a television receiver, a satellite broadcasting receiver, a video recorder, a mobile communication appliance, and the like. The present invention is to provide a phase shifter operable even under low power supply voltage and also firmly operable in a wide frequency range, and furthermore, to provide an impedance circuit corresponding to a basic circuit arrangement which can be applied to this phase shifter in such the below-mentioned manner. That is, while transistors corresponding to each other are series-connected with each other to thereby form both a first differential pair and a second differential pair, since a current of this first differential paired transistor is shunted and the shunted current drives the second differential paired transistor in a reverse polarity, a desired impedance is formed as viewed from an input side of the first differential paired transistor in such a manner that an impedance appearing in the emitter of the first differential paired transistor is canceled by another impedance appearing in the emitter of the second differential paired transistor. Also, this impedance is set to be capacitive impedance.

Description of the Related Art

Conventionally, in a signal processing circuit such as a television receiver, a detecting circuit, a demodulating circuit, and the like are arranged by employing a phase shifter.

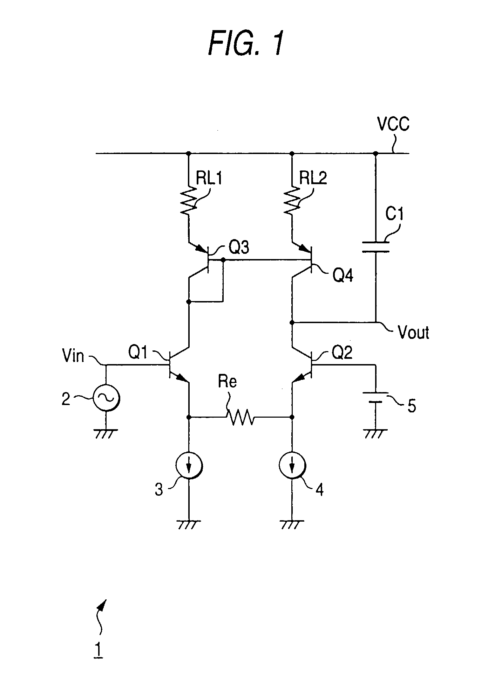

That is, Fig. 1 is a connection diagram for representing a basic structure of this sort of phase shifter. In this phase shifter 1, one of an NPN type transistor Q1 and another NPN type transistor Q2, which constitute a differential pair, is connected to a signal source 2. In this case, emitters of these transistors Q1 and Q2 are connected to a current source 3 and another current source 4, respectively, and also an emitter resistor "Re" is connected between these emitters. Furthermore, as to these transistors Q1 and Q2, a base of the other transistor Q2 is biased by a DC power supply 5, and collectors of a PNP type transistor Q3 and another PNP type transistor Q4 are connected to the respective collectors of these NPN type transistors Q1 and Q2.

Among these transistors, the transistor Q3 connected to the transistor Q1 provided on the side of the signal source 2 is connected via an emitter resistor RL1 to a power supply VCC, and the base of this transistor Q3 is commonly connected to the other transistor Q4 by a diode. In contrast, the other transistor Q4 is similarly connected via another emitter resistor RL2 to the power supply VCC.

In the phase shifter 1, on the side of the other transistor Q4, a capacitor C1 is arranged between a junction point between these transistors Q2 and Q4, and the power supply VCC. Accordingly, the phase shifter 1 is arranged in such a manner that a charging/discharging current may be supplied to the capacitor C1 by the transistor Q2 in response to an input voltage Vin derived from the signal source 2, and then an output voltage Vout having a phase shifted by 90 degrees with respect to the input voltage Vin may be outputted.

On the other hand, in order to obtain the output voltage Vout whose phase is shifted by 90 degrees with respect to the input voltage Vin by the correct operation of this phase shifter 1, the impedance parallel to the capacitor C1 must be sufficiently larger than the impedance of this capacitor C1. In other words, assuming now that the impedance as viewed from both end terminals of this capacitor C1 is "Z" and the capacitance of the capacitor C1 is "C", the cut off frequency 1/ZC must be sufficiently lower than the frequency of the input voltage Vin.

As a result, in order to increase the impedance parallel to this capacitor C1, normally, various circuit arrangements are conceivable. Eventually, in order that the used frequency range is extended and the phase shifter 1 is operable in the low frequency band, the capacitance of the capacitor C1 must be increased. As a consequence, the conventional phase shifter owns such a difficult problem that it is firmly operable over such a wide frequency range.

Also, in such a phase shifter having the structure as shown in Fig. 1, the collector impedance of the transistor constitutes the parallel impedance of this capacitor C1. In this case, the NPN type transistor and the PNP type transistor are arranged in such a manner that these collectors are directly connected to each other.

In such a structure that the NPN type transistor and the PNP type transistor are arranged while the collectors thereof are directly connected to each other, there is a problem that the phase shifter can be hardly operated under low power supply voltage.

Also, since the transistors are arranged on both sides of the power supply and the ground, the bias is required. As a result, it is difficult to operate the phase shifter under low power supply voltage.

As an example, generally speaking, in an integrated circuit, a characteristic of a PNP type transistor is deteriorated, as compared with that of an NPN type transistor. As a consequence, in such a structure that the NPN type transistor and the PNP type transistor are arranged while the collectors thereof are directly connected in this manner, there is a drawback that the usable frequency range is limited even by this PNP type transistor with such a deteriorated characteristic.

Also, in the structure such that the NPN transistor and the PNP transistor are arranged while the collectors thereof are directly connected to each other, it is required to employ the feedback circuit for setting the collector potential. Eventually, in the phase shifter having the structure as shown in Fig. 1, the feedback circuit is arranged by the operational amplifying circuit. In this case, there are such drawbacks that the usable frequency range is limited by the GB product of the operational amplifying circuit, and also the offset voltage is produced between the output terminal.

## SUMMARY OF THE INVENTION

The present invention has been made to solve the above-described drawbacks, and therefore, has an object to provide a phase shifter operable even under low power supply voltage, and also firmly operable in a wide frequency range, and furthermore, to provide an impedance circuit corresponding to a basic circuit arrangement which can be applied to this phase shifter.

To solve the above-described problems, an impedance circuit, according to the present invention, is featured by comprising: a first differential paired transistor for inputting thereinto a signal derived from a signal source; a second differential paired transistor, the collector of which is connected to emitters of the first differential paired transistor respectively, and the other collector of which is connected to the base thereof; and a 2-terminal circuit connected between emitters of the second differential paired transistor.

Also, a phase shifter, according to the present invention, is featured by comprising: a first differential paired transistor; a second differential paired transistor, the collector of which is connected to emitters of the first differential paired transistor respectively, and the other collector of which is connected to a base thereof; and a capacitor connected between emitters of the second differential paired transistor.

When the phase shifter is further comprised of a second differential paired transistor, the collector of which is connected to emitters of the first differential paired transistor respectively, and the other collector of which is connected to a base thereof; and a 2-terminal circuit connected between emitters of the second differential paired transistor, the first differential paired transistor can be driven in such a manner that either the impedance existing in the emitter of the first differential paired transistor or the impedance connected to this emitter is canceled by either the impedance existing in the emitter of the second differential paired transistor or the impedance connected to this emitter of the second differential paired transistor. Also, as viewed from the input side of the first differential paired transistor, either the impedance of the 2-terminal circuit network connected between the emitters of the second differential paired transistor or such an impedance defined by reversing the polarity of this impedance can be formed. At this time, this impedance circuit can be arranged even in such a case that the stray capacitance of the emitter can be canceled, and also even such a PNP type transistor is not used. As a result, the impedance circuit can be operated even under low power supply voltage, and also can be firmly operated in the wide frequency range.

As a consequence, since the capacitor is applied to this 2-terminal circuit, such a phase shifter that can be operated even under low power supply voltage, and also can be firmly operated in the wide frequency range can be realized.

## BRIEF DESCRIPTION OF THE DRAWINGS

For a better understanding of the present invention, reference is made of a detailed description to be read in conjunction with the accompanying drawings, in which:

Fig. 1 is a circuit diagram of a conventional phase shifter.
Fig. 2 is a circuit diagram for showing an impedance circuit according to a first embodiment mode of the present invention;
Fig. 3 is a circuit diagram used to explain the impedance circuit of Fig. 2;
Fig. 4 is a circuit diagram for representing an impedance circuit according to a second embodiment mode of the present invention;
Fig. 5 is a circuit diagram for representing an impedance circuit according to a third embodiment mode of the present invention; and
Fig. 6 is a circuit diagram for showing a phase shifter according to a fourth embodiment mode of the present invention.

**DETAILED DESCRIPTION OF THE PREFERRED EMBODIMENTS**

Referring now to drawings, an embodiment mode of the present invention will be described in detail.

(1) FIRST EMBODIMENT MODE

(1-1) ARRANGEMENT OF FIRST EMBODIMENT MODE

Fig. 1 is a connection diagram for showing an impedance circuit according to a first embodiment mode of the present invention. This impedance circuit 10 cancels impedances existing between emitters in differential paired transistors, and forms a desirable impedance "Z0", as viewed from a signal source 11 and a signal source 12 for differential outputs.
In other words, in the impedance circuit 10, the signal source 11 and the signal source 12, which produce the differential outputs, are connected to the respective collectors of the transistor Q1 and the transistor Q2, which correspond to a differential pair. The emitters of these transistors Q1 and Q2 in this impedance circuit 10 are connected via first impedances 13 and 14 each having a value of "Z1" to a transistor Q3 and a transistor Q4, which constitute a differential pair. Furthermore, a base and a collector of these transistors Q1 and Q2 are connected to an emitter and a base of the transistors Q5 and Q6, respectively. Each of these transistors Q5 and Q6 is connected between a power supply VCC and the ground in series to current sources 19 and 20.
In this impedance circuit 10, emitters of the transistors Q3 and Q4 are connected via second impedances 15 and 16 having the same values as those of the first impedances to current sources 17 and 18. The other terminal of the second impedance 15 and the other terminal of the second impedance 16 are connected to each other by a third impedance 22 having a value of "2Z0". In addition, one collector of the transistor Q3 and one collector of the transistor Q4 are connected to the other base thereof.
As a result, the transistors Q3 and Q4 shunt a current on the side of collectors, which flows through an impedance (2Z1 + 2Z0) between the emitters thereof by the signal sources 11 and 12. While polarities of the shunted currents are reversed and these shunted currents are supplied so as to drive the opposite transistors Q4 and Q3, these transistors Q3 and Q4 vary emitter currents of the transistors Q1 and Q2 in such a manner that the impedances(z1) 13 and 14 having the values of "Z1" are canceled which are connected to these transistors Q1 and Q2 corresponding to the first differential pair.
It should be noted that the impedances 13, 14, 15, and 16 in this impedance circuit are emitter resistances of the transistors Q1, Q2, Q3, and Q4, respectively.

(1-2) OPERATION OF FIRST EMBODIMENT MODE

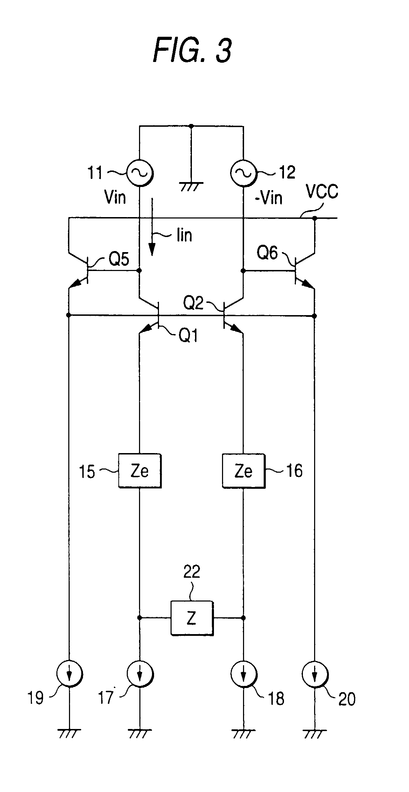

In the above-described circuit arrangement, the transistors Q1 and Q2 are current-driven by the signal sources 11 and 12, which are arranged in the differential output structure, the emitter currents are supplied to the transistors Q3 and Q4. The current values of these emitter currents are changed in a complementary manner in response to a voltage "Vin" of the signal source 11 and another voltage "-1Vin" of the signal source 12. In these transistors Q3 and Q4, the emitter currents will flow through the impedances 15 and 16, and then a difference current between these emitter currents will flow through the impedance 22. The impedances 15 and 16 own the same values as those of the impedances 13 and 14 arranged in the emitters of the transistors Q1 and Q2.
In the impedance circuit 10 in which the currents are derived from the signal sources 11 and 12 in this manner, the current flowing through the impedance (2Z1 + 2Z0) existing between the emitters of the transistors Q3 and Q4 is shunted on the side of the collectors thereof, and the polarities of the shunted currents are inverted. Then, since the polarity-inverted shunted currents are supplied to the bases of the transistors Q4 and Q3, the opposite transistors Q4 and Q3 are driven. As a result, in the impedance circuit 10, the emitter currents of the transistors Q1 and Q2 are varied in a manner in which the impedances 13 and 14 connected to the transistors Q1 and Q2 which constitute the first differential pair are canceled.
As a consequence, in this impedance circuit 10, the impedance, as viewed from the signal sources 11 and 12, is maintained at a value of "-Z0" equal to - 1/2 value of the impedance 22 connected between the emitters of these transistors Q3 and Q4.
In other words, for the sake of a simple explanation, as indicated in Fig. 3, such a circuit arrangement from which both the transistors Q3 and Q4 related to this second differential pair are omitted will now be investigated. In this circuit arrangement shown in Fig. 3, a current Iin supplied from the signal source 11 may be expressed by the below-mentioned formula. It should be understood in this formula that the impedances 15, 16, 22 connected to the emitters of the transistors Q1 and Q2 are assumed as impedances Ze, Ze, and Z, respectively:

$$[\text{Formula 1}] \qquad Iin = \frac{-Vin}{2Ze + Z} \qquad\qquad (1)$$

As a result, an impedance "Zin", as viewed from the signal sources 11 and 12, may be expressed by the below-mentioned formula:

[Formula 2]

$$Zin = \frac{Vin}{Iin}$$

$$= (2Ze + Z)$$

$$= -Z(1 + \frac{2Ze}{z})$$

$$\text{--- } (2)$$

Accordingly, in this case, if 2Ze << Z, then the following related formula can be established, and also the impedance as viewed from the signal sources 11 and 12 may be set to such an impedance of "-Z" having a symbol inverted from the symbol of the impedance connected between the emitters of the transistors Q1 and Q2:

$$[\text{Formula 3}] \qquad Zin = \frac{Vin}{Iin} \cong -Z \qquad\qquad (3)$$

However, when this related formula can be established, only the following condition is satisfied: 2Ze << Z. In this case in which this impedance "Ze" cannot be neglected, the impedance "Zin" as viewed from the signal sources 11 and 12 cannot be specified.

To the contrary, in the impedance circuit 10 according to this embodiment mode, since the impedance Z1 arranged on the side of the emitters of the transistors Q1 and Q2 is canceled, the impedance Zin as viewed from the signal sources 11 and 12 can be maintained as the value of "-Z0".

That is to say, in the impedance circuit 10, assuming now that a collector potential at the transistors Q3 and Q4 which correspond to the second deferential pair is equal to "V1", the below-mentioned related formula may be obtained:

[Formula 4]

$$Iin = \frac{Vin - V1}{Z1}$$

$$= \frac{-V1}{Z1 + Z0}$$

$$\text{--- } (4)$$

As a result, the following related formula may be obtained:

[Formula 5]

$$\frac{V1}{Vin} = \frac{Z1 + Z0}{Z1}$$

$$= Z1(1 + \frac{Z0}{Z1})$$

--- (5)

When this formula (5) is substituted for the below-mentioned formula and is rearranged, it can be seen that the input impedance of this impedance circuit 10 becomes "-Z0", as viewed from the signal source 11 and 12:

[Formula 6]

$$Iin = \frac{Vin - V1}{Z1}$$

$$= (1 - \frac{V1}{Vin})\frac{Vin}{Z1}$$

$$= \frac{-Vin}{Z0}$$

--- (6)

[Formula 7]

$$Zin = \frac{Vin}{Iin}$$

$$= -Z0$$

--- (7)

(1-3) EFFECTS OF THE FIRST EMBODIMENT MODE

In accordance with the above-described circuit arrangement, the first differential paired transistor can be operated as follows: That is, while transistors corresponding to each other are series-connected with each other to thereby form both the first differential pair and the second differential pair, since the current of this first differential paired transistor is shunted and the shunted current drives the second differential paired transistor in the reverse polarity, the desired impedance is formed as viewed from the input side of the first differential paired transistor in such a manner that the impedance appearing in the emitter of the first differential paired transistor is canceled by another impedance appearing in the emitter of the second differential paired transistor.

Accordingly, while the impedance circuit is formed in an IC form, the desired impedance "-Z0" can be formed by neglecting the influence caused by the emitter resistance. In other words, in all of the differential pairs provided in the integrated circuit, the impedances existing between the emitters of the differential pairs can be canceled. At the same time, since the canceling amount of the impedance is controlled, a desirable impedance may be freely formed. At this time, a polarity of this desirable impedance may be freely set.

As a consequence, for example, in the case that a gain of a differential amplifying circuit is determined based upon a ratio of an emitter resistance to a collector resistance, a load resistance thereof can be set to a desirable value and also set to a negative impedance, and thus, a differential amplifying circuit having a very high gain can be constructed. Also, since no care should be taken to a bias aspect, this differential amplifying circuit can be operated under low voltage.

Moreover, when a negative capacitance capable of canceling a stray capacitance is formed, lowering of a frequency band and of a gain, which is caused by the stray capacitance, can be prevented.

Also, while the negative capacitance capable of reducing the collector capacitance corresponding to the stray capacitance is formed, this collector capacitance may be set to a desirable capacitance value in higher precision. As a result, the impedance circuit is applied to a radio frequency filter and the like, a very small capacitance may be simply formed. Since such a very small capacitance may be formed, the operation frequency may be extended and the circuit network operable under low operation voltage may be formed.

It should also be understood that when the frequency band and the gain are restricted by the stray capacitance, conventionally, in order that the phase variation is avoided and the desirable gain is obtained, the amplifying circuits are cascade-connected to each other. To the contrary, if the impedance converting circuit according to this embodiment mode is applied so as to extend the usable frequency range with a high gain, then the total stage number of amplifying circuits connected in the cascade manner can be reduced, so that the overall circuit arrangement can be made simpler. Therefore, the high-performance amplifying circuit can be obtained with employing a smaller number of circuit elements, and while the amplifying circuit is formed in an IC form, the entire IC chip area can be reduced and the power consumption can be reduced.

In addition, the impedance converting circuit of this embodiment mode is applied to various sorts of circuits, so that the circuit performance characteristics which are conventionally deteriorated by presence of the emitter resistance in the differential paired transistor can be improved.

## (2) SECOND EMBODIMENT MODE

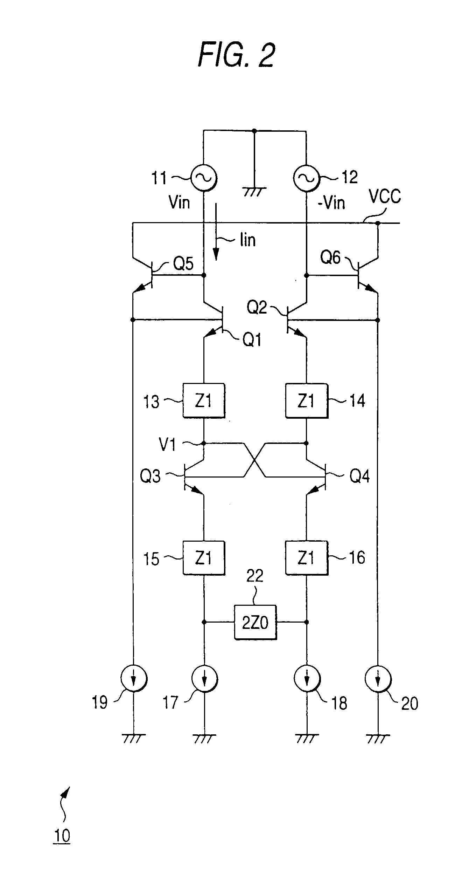

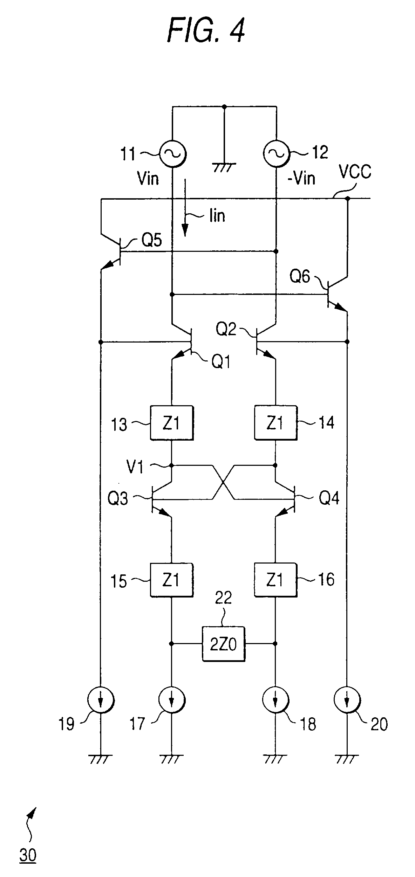

Fig. 4 is a connection diagram for indicating an impedance circuit according to a second embodiment mode of the present invention. In this impedance circuit 30, with respect to an impedance "2Z0" connected between emitters of second differential paired transistors Q3 and Q4, an input impedance having the same polarity and also the same value as those of this impedance "2Z0" is formed. It should be noted the same reference numerals shown in Fig. 2 will be employed as those for denoting the same, or similar circuit elements of the circuit arrangement indicated in Fig. 4, and therefore, description thereof are omitted.

In this embodiment mode, the impedance circuit 30 is arranged identical to the above-explained impedance circuit 10 of Fig. 2 except that the collectors of the transistors Q1 and Q2 which constitute the first differential pair are connected to the bases of the transistors Q6 and Q5, instead of the bases of the transistors Q5 and Q6.

In other words, in the circuit arrangement shown in Fig. 4, the following formula may be obtained. Since this formula is sequentially modified in a similar manner to that of the first embodiment mode, an input impedance "Z0" as viewed from the signal sources 11 and 12 may be obtained:

[Formula 8]

$$Iin = \frac{-Vin + V1}{Z1}$$

$$= \frac{V1}{Z1 + Z0}$$

$$--- (8)$$

[Formula 9]

$$\therefore \frac{V1}{Vin} = \frac{Z1 + Z0}{Z1}$$

$$= Z(1 + \frac{Z0}{Z1}$$

$$--- (9)$$

[Formula 10]

$$Iin = \frac{-Vin + V1}{Z1}$$

$$= (-1 + \frac{V1}{Vin})\frac{Vin}{Z1}$$

$$= \frac{Vin}{Z0}$$

--- (10)

[Formula 11]

$$Zin = \frac{Vin}{Iin}$$

$$= Z0$$

--- (11)

In accordance with the circuit arrangement shown in Fig. 4, the input impedances having the same polarities can be freely set.

(3) THIRD EMBODIMENT MODE

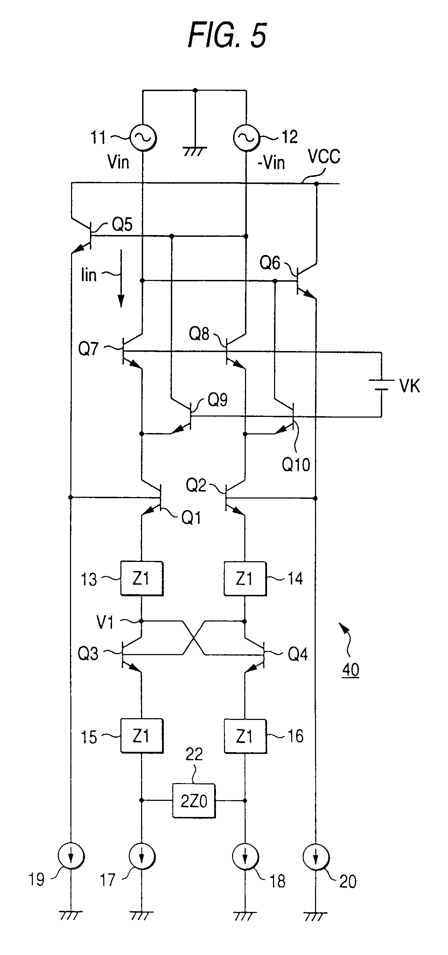

Fig. 5 is a connection diagram for indicating an impedance circuit according to a third embodiment mode of the present invention. In this impedance circuit 40, the same reference numerals shown in Fig. 4 will be employed as those for denoting the same, or similar circuit elements of the circuit arrangement 30 indicated in Fig. 4, and therefore, descriptions thereof are omitted.

In this impedance circuit 40, a shunt circuit is arranged between the transistors Q5 / Q6 and the transistors Q1 / Q2. In other words, in this impedance circuit 40, a transistor Q7 is interposed between the signal source 11 and the collector of the transistor Q1, whereas another transistor Q9 is interposed between the base of the transistor Q5 and the collector of the transistor Q1. Furthermore, a transistor Q8 is interposed between the signal source 12 and the collector of the transistor Q2, whereas another transistor Q10 is interposed between the base of the transistor Q6 and the collector of the transistor Q2.

In the impedance circuit 40, a potential difference between the bases of these transistors Q7 / Q9 and the bases of these transistors Q8 / Q10 is set by a controlling power supply VK. As a consequence, both a ratio of currents flowing into the transistor Q1 from the signal sources 11 and 12 can be varied, and a ratio of currents flowing into the transistors Q2 from the signal sources 11 and 12 can be varied.

Furthermore, in this impedance circuit 40, a capacitor is arranged as an impedance 22 between the emitters of the second differential paired transistors Q3 and Q4. As a result, the impedance circuit 40 is arranged in a manner in which while the controlling power supply VK is variable, the capacitive impedance circuit is constructed, as viewed from the signal sources 11 and 12, and further, this capacitance is variable by the controlling power supply VK.

That is to say, assuming now that the current shunting ratio by the controlling power supply VK is equal to "k" and the capacitance of the impedance 22 is equal to "C", in this impedance circuit 40, the following related formulae can be obtained in a similar manner to the above-explained embodiment mode:

[Formula 12]

$$Iin = k \cdot \frac{-Vin - V1}{Z1}$$

$$= \frac{-k \cdot Vin}{Z0}$$

$$--- (12)$$

In this formula, since Z0 = 1/sC, the above formula (12) may be modified as follows:

[Formula 13]    $Iin = -k \cdot Vin \cdot sC$

$$s = j\omega \qquad\qquad (13)$$

Accordingly, since this formula is solved, the below-mentioned related formula may be obtained while setting the input impedance "Zin":

[Formula 14]    $Zin = \dfrac{Vin}{Iin} = \dfrac{-1}{k \cdot sC}$

$$-1 < k < 1 \qquad\qquad (14)$$

In accordance with the circuit arrangement shown in Fig. 5, since the current shunting ratio is variable, the input impedances can be varied while neglecting the influence caused by the emitter resistance. Also, in this case, a capacitance is arranged with the impedance 22, so that a variable capacitance capacitor may be formed.

(4) FOURTH EMBODIMENT MODE

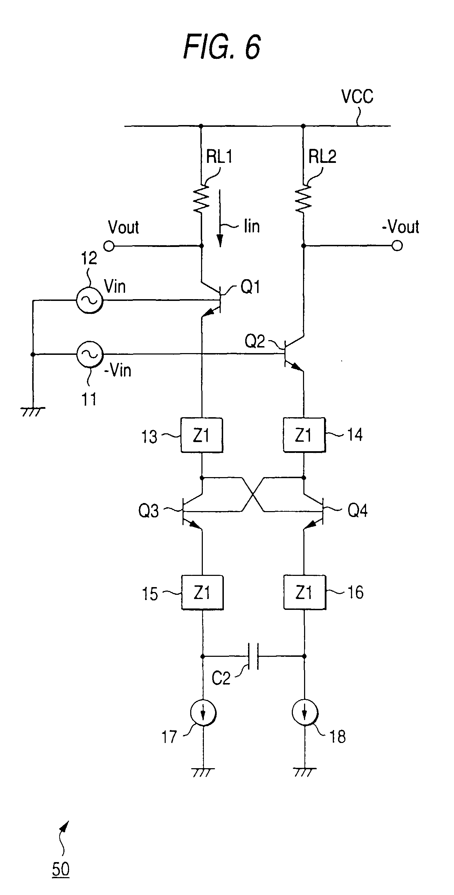

Fig. 6 is a connection diagram for showing a phase shifter according to a fourth embodiment of the present invention. In this phase shifter 50, it should also be noted that the same reference numerals shown in the above-described impedance circuit will be employed as those for denoting the same, or similar circuit elements thereof, and therefore, descriptions thereof are omitted.

In this phase shifter 50, both a signal source 11 and a signal source 12 are connected to bases of first differential paired transistors Q1 and Q2, and the collectors of the first differential paired transistors Q1 and Q2 are connected via collector resistors RL1 and RL2 to the power supply VCC. As a result, the phase shifter 50 current-to-voltage-converts currents flowing through the first differential paired transistors Q1 and Q2 by way of these collector resistors RL1 and RL2 to output both an output voltage Vout and another output voltage "-Vout".

Furthermore, in the phase shifter 50, a capacitor C/2 is arranged as an impedance connected between the emitters of the second differential paired transistors Q3 and Q4. As a result, an impedance, as viewed from the output terminal to the side of the first differential paired transistors, may be made equal to a capacitive impedance constructed of the capacitor C/2.

As a consequence, in the phase shifter 50, as to a current "Iin" which flows through the first differential paired transistors by the collector resistor RL1, the below-mentioned related formula may be obtained:

[Formula 15]

$$Iin = \frac{Vin - V1}{Z1}$$

$$= \frac{-V1}{Z1 + 1/sC}$$

$$\therefore \frac{V1}{Vin} = 1 + Z1 \cdot sC$$

--- (15)

As a result, this formula is solved in a similar manner to that of the above-described embodiment mode, so that the below-mentioned related formula may be obtained:

[Formula 16]

$$Iin = (1 - \frac{V1}{Vin})\frac{Vin}{Z1}$$

$$= \frac{-Vin(Z1 \cdot sC)}{Z1}$$

$$= -Vin \cdot sC$$

--- (16)

[Formula 17]

$$Vout = -Iin \cdot RL$$

$$= Vin \cdot sC \cdot RL$$

--- (17)

As a result, it can be seen that the phase of the output voltage Vout is shifted by 90 degrees with respect to that of the input signal Vin.

In accordance with the circuit arrangement shown in Fig. 6, while the transistors corresponding to each other are series-connected with each other to thereby form both the first differential pair and the second differential pair, since the current of this first differential paired transistor is shunted and the shunted current drives the second differential paired transistor in the reverse polarity, a desired impedance can be formed as viewed from the input side of the first differential paired transistor in a manner in which the impedance appearing in the emitter of the first differential paired transistor is canceled by another impedance appearing in the emitter of the second differential paired transistor. As a result, while this impedance is set to be capacitive impedance, the phase shifter can be arranged. In accordance with this phase shifter, the phase can be correctly changed by 90 degrees without being restricted by the conventional condition. That is, a condition that the impedance arranged in parallel to this capacitor must be sufficiently larger than the impedance of this capacitor, in a conventional case in which the impedance is arranged in parallel to the capacitor so as to arrange the conventional phase shifter. As a consequence, while increasing of the capacitance can be effectively avoided, the overall shape of the phase shifter can be made compact, and also the frequency range under use can be considerably extended.

Also, the capacitive impedance can be formed between the emitters of the differential paired transistors without employing the PNP type transistor. Thus, the phase shifter can be constituted by employing a small number of elements and further can be operated under low voltage, when this phase shifter is manufactured in, for example, an IC form, the chip area thereof can be reduced and also the power consumption can be lowered.

Also, since the emitter resistors of the differential paired transistors are canceled by each other, the phase error caused by the emitter resistors can be prevented.

(5) OTHER EMBODIMENT MODES

It should be understood that in the above-explained fourth embodiment mode, the currents flowing through the first differential paired transistors Q1 and Q3 are current-to-voltage-converted by way of the resistors RL1 and RL2 to output the output signal Vout, but the present invention is not limited thereto. Alternatively, the 90-degree phase shifter may be arranged as follows: That is, since the phase of the current flowing through the impedance C/2 has been shifted by 90 degrees as represented in the formula (16), in a case in which various sorts of circuits subsequent to this 90-degree phase shifter are driven by the current output, this phase shifter may directly output the current without processing this current by the current-to-voltage converting process operation, if required.

Furthermore, it should be understood that in the above-explained third embodiment mode, the input impedance of the impedance circuit is made capacitive, and this capacitance is variable, but the present invention is not limited thereto. Alternatively, while various sorts of impedances are formed, these formed impedances may be varied.

As previously described, in accordance with the present invention, the impedance circuit can be arranged by that while the transistors corresponding to each other are series-connected with each other to thereby form both the first differential pair and the second differential pair, since the current of this first differential paired transistor is shunted and the shunted current drives the second differential paired transistor in the reverse polarity, the desired impedance is formed as viewed from the input side of the first differential paired transistors in a manner in which the impedance appearing in the emitter of the first differential paired transistor is canceled by another impedance appearing in the emitter of the second differential paired transistor and also be reliably operated under low power supply voltage and in the extended frequency range.

Also, a phase shifter can be formed in which this impedance is set to the capacitive characteristic, thereby enabling to be operated even under low power supply voltage, and also be firmly operated in the wide frequency range.

**Claims**

1. A semiconductor circuit comprising:

   a first differential amplifier constituted by a first transistor (Q1) and a second transistor (Q2), the collectors of which are connected to a signal source (Vin, -Vin); and
   a second differential amplifier constituted by a third transistor (Q3) and a fourth transistor (Q4), characterized in that:
   a collector of said third transistor (Q3) is connected to an emitter of said first transistor (Q1), and said collector of the third transistor (Q3) is connected to a base of said fourth transistor (Q4);
   a collector of said fourth transistor (Q4) is connected to an emitter of said second transistor (Q2), and said collector of the fourth transistor (Q4) is connected to a base of the third transistor (Q3); and
   a first circuit (10) having a predetermined impedance is connected between the emitter of said third transistor (Q3) and the emitter of said fourth transistor (Q4).

2. A semiconductor circuit as claimed in claim 1 characterized in that:
   said signal source contains a first signal source (Vin) and a second signal source (-Vin); and both of said first signal source and said second signal source are operated in a complementary manner.

3. A semiconductor circuit as claimed in claim 1 characterized by further comprising:

   a fifth transistor (Q5), the base of which is connected to the collector of said first transistor (Q1), and also the emitter of which is connected to the base of said first transistor (Q1); and
   a sixth transistor (Q6), the base of which is connected to the collector of said second transistor (Q2), and also the emitter of which is connected to the base of said second transistor (Q2).

4. A semiconductor circuit as claimed in claim 1 characterized by further comprising:

   a fifth transistor (Q5), the base of which is connected to the collector of said second transistor (Q2), and also the emitter of which is connected to the base of said first transistor (Q1); and
a sixth transistor (Q6), the base of which is connected to the collector of said first transistor (Q1), and also the emitter of which is connected to the base of said second transistor (Q2).

5. A semiconductor circuit as claimed in claim 1 characterized by further comprising:

seventh and eighth transistors (Q7, Q8) series-connected between said signal source (Vin, -Vin) and the collectors of said first and second transistors (Q1, Q2);
a ninth transistor (Q9), the collector of which is connected to the collector of said eighth transistor (Q8), and also the emitter of which is connected to the collector of said first transistor (Q1); and
a tenth transistor (Q10), the collector of which is connected to the collector of said seventh transistor (Q7), and also the emitter of which is connected to the collector of said second transistor (Q2); and characterized in that:
a controlling power supply (VK) is connected to the bases of said seventh, eighth, ninth, and tenth transistors (Q7, Q8, Q9, Q10).

6. A semiconductor circuit as claimed in claim 5 characterized in that: said first circuit is a capacitance.

7. A semiconductor circuit as claimed in claim 4 characterized by further comprising:

seventh and eighth transistors (Q7, Q8) series-connected between said signal source (Vin, -Vin) and the collectors of said first and second transistors (Q1, Q2);
a ninth transistor (Q9), the collector of which is connected to the collector of said eighth transistor (Q8), and also the emitter of which is connected to the collector of said first transistor (Q1); and
a tenth transistor (Q10), the collector of which is connected to the collector of said seventh transistor (Q7), and also the emitter of which is connected to the collector of said second transistor (Q2); and characterized in that:
a controlling power supply (VK) is connected to the bases of said seventh, eighth, ninth, and tenth transistors (Q7, Q8, Q9, Q10).

8. A semiconductor circuit comprising:

a first differential amplifier constituted by a first transistor (Q1) and a second transistor (Q2), the bases of which are connected to a signal source (Vin, - Vin); and
a second differential amplifier constituted by a third transistor (Q3) and a fourth transistor (Q4), characterized in that:
a collector of said third transistor (Q3) is connected to an emitter of said first transistor (Q1), and said collector of the third transistor (Q3) is connected to a base of said fourth transistor (Q4);
a collector of said fourth transistor (Q4) is connected to an emitter of said second transistor (Q2), and said collector of the fourth transistor (Q4) is connected to a base of the third transistor (Q3); and
a first circuit (10) having a predetermined impedance is connected between the emitter of said third transistor (Q3) and the emitter of said fourth transistor (Q4).

9. A semiconductor circuit as claimed in claim 8 characterized in that: said first circuit is a capacitance.

10. A semiconductor circuit as claimed in claim 8 characterized in that:
said signal source contains a first signal source (Vin) and a second signal source (-Vin); and both of said first signal source and said second signal source are operated in a complementary manner.

11. A semiconductor circuit as claimed in claim 8 characterized in that:
the respective collectors of said first transistor (Q1) and said second transistor (Q2) are connected via a load to a power supply.

# FIG. 1

## FIG. 2

## FIG. 3

## FIG. 4

# FIG. 5

## FIG. 6

50